# EUROPEAN PATENT APPLICATION

(11) **EP 4 822 743 A1**
(43) Date of publication of application: **14.10.2026**
(21) Application number: 24900372.4
(22) Date of filing: 07.11.2024
(51) Int. Cl.: H01L 23/36, H01L 23/373, H05K 7/20

(54) **THERMALLY-CONDUCTIVE SHEET AND THERMALLY-CONDUCTIVE SHEET PRODUCTION METHOD**

(30) Priority: 05.12.2023 JP 2023205183
(71) Applicant: Dexerials Corporation, Shimotsuke-shi, Tochigi 323-0194 (JP)
(72) Inventor: IWATA, Yuki, Shimotsuke-shi, Tochigi 323-0194 (JP); NAMIKI, Hidetsugu, Shimotsuke-shi, Tochigi 323-0194 (JP); SHIMADA, Kazuto, Shimotsuke-shi, Tochigi 323-0194 (JP)
(74) Representative: Fleuchaus & Gallo Partnerschaft mbB
(86) International application number: PCT/JP2024/039715
(87) International publication number: WO 2025/121077

(57) **Abstract**

A thermally-conductive sheet including: a metal part including a metal layer and a metal projection on at least a first surface of the metal layer; and an adhesive part on the first surface, wherein an area ratio of the metal projection exposed on the first surface of the thermally-conductive sheet to the first surface is 20% or greater and 80% or less, and a ratio (Tₘ/T_{M}) of an average thickness (Tₘ) of the metal projection to an average thickness (Tₘ) of the metal layer is 0.125 or greater and 8 or less.

## Description

### TECHNICAL FIELD

The present invention relates to a thermally-conductive sheet and a thermally-conductive sheet production method.

### BACKGROUND ART

With the size reduction of electronic devices, such as power modules, image sensors, High-Performance Computing (HPC), and the like, and the increase in the amount of information processing, the heat generation problem has become more pronounced, and the importance of heat diffusion from heat sources has been increasing.

If LSIs or the like of various electronic devices are themselves exposed for a long time to a high temperature due to heat generation from the elements used thereon, there is a risk that the LSIs might malfunction or break down. Therefore, thermally-conductive materials are widely used to prevent the temperature rise of the LSIs or the like. The thermally-conductive materials can prevent the temperature rise of the devices by diffusing heat generated by the elements or by conducting the heat to a heat dissipation member configured to radiate the heat to the outside of the system, such as the open air and the like.

So far, a thermally-conductive sheet in which graphite layers containing anisotropic graphite particles are laminated and the graphite layers are joined via a resin layer has been reported (for example, see PTL 1). Further, a thermally-conductive insulating sheet containing an uncured product and/or a semi-cured product of a thermally-conductive insulating filler and a binder resin, which is a thermosetting resin, and having a thickness of 25 µm or greater has been reported (for example, see PTL 2).

### CITATION LIST

### PATENT LITERATURE

PTL 1: Japanese Patent Application Laid-Open Publication No. 2009-055021
PTL 2: Japanese Patent Application Laid-Open Publication No. 2019-029269

### SUMMARY OF THE INVENTION

### TECHNICAL PROBLEM

However, the thermally-conductive sheet described in PTL 1, in which the graphite layers have anisotropy and the resin layer is contained, is problematic in that the thermal conductivity is insufficient because of a limited heat path and that the adhesiveness between the graphite and metal is poor. Further, the thermally-conductive insulating sheet described in PTL 2 having insulating properties is problematic in that the thermal conductivity is not sufficient.

The present invention aims for solving the various conventional problems described above, and for achieving the following object. That is, it is an object of the present invention to provide a thermally-conductive sheet that can achieve both high thermal conductivity and reliability.

### SOLUTION TO THE PROBLEM

Means for solving the problems are as follows.
<1> A thermally-conductive sheet, including:
   a metal part including a metal layer and a metal projection on at least a first surface of the metal layer; and
   an adhesive part on the first surface,
   wherein an area ratio of the metal projection exposed on the first surface of the thermally-conductive sheet to the first surface is 20% or greater and 80% or less, and
   a ratio (Tₘ/T_{M}) of an average thickness (Tₘ) of the metal projection to an average thickness (T_{M}) of the metal layer is 0.125 or greater and 8 or less.
<2> The thermally-conductive sheet according to <1>, further including:
   a metal projection and an adhesive part on a second surface of the metal layer opposite to the first surface,
   wherein an area ratio of the metal projection exposed on the second surface of the thermally-conductive sheet to the second surface is 20% or greater and 80% or less.
<3> The thermally-conductive sheet according to <1> or <2>,
   wherein the area ratio of the metal part exposed on the first surface of the thermally-conductive sheet to the first surface is 30% or greater and 70% or less.
<4> The thermally-conductive sheet according to any one of <1> to <3>,
   wherein the ratio (Tₘ/T_{M}) of the average thickness (Tₘ) of the metal projection to the average thickness (T_{M}) of the metal layer is 0.2 or greater and 4 or less.
<5> The thermally-conductive sheet according to any one of <1> to <4>,
   wherein a thermal conductivity of the metal layer is 50 W/(m·K) or greater.
<6> The thermally-conductive sheet according to any one of <1> to <5>,
   wherein the metal layer contains at least any one of gold, silver, copper, aluminum, or nickel.
<7> The thermally-conductive sheet according to any one of <1> to <6>,
   wherein the metal projection is a metal formed by electrolytic plating.
<8> The thermally-conductive sheet according to any one of <1> to <7>,
   wherein the adhesive part contains at least any one of a modified acrylate compound, an epoxy resin, an unsaturated polyester resin, a polyurethane resin, a bismaleimide resin, an alkyd resin, a phenolic resin, or a melamine resin.
<9> A thermally-conductive sheet production method, including:
   applying a protective part to at least a first surface of a metal layer; and
   forming a metal projection on an exposed surface of the metal layer to which the protective part is not applied.
<10> The thermally-conductive sheet production method according to claim 9, further including:
   removing the protective part; and
   filling an adhesive part on an exposed surface of the metal layer from which the protective part is removed.
<11> The thermally-conductive sheet production method according to <9> or <10>,
   wherein the applying of the protective part includes applying the protective part to the first surface of the metal layer and to a second surface of the metal layer opposite to the first surface.

### ADVANTAGEOUS EFFECTS OF THE INVENTION

According to the present invention, it is possible to solve the various conventional problems described above, to achieve the object described above, and to provide a thermally-conductive sheet that can achieve both high thermal conductivity and reliability.

### BRIEF DESCRIPTION OF THE DRAWINGS

[FIG. 1] FIG. 1 is a schematic cross-sectional view showing an example of a thermally-conductive sheet according to the present embodiment.
[FIG. 2A] FIG. 2A is a cross-sectional view of the thermally-conductive sheet of FIG. 1 along A-A'.
[FIG. 2B] FIG. 2B is a cross-sectional view of another example of the thermally-conductive sheet according to the present embodiment along A-A'.
[FIG. 3A] FIG. 3A is a schematic cross-sectional view showing another example of the thermally-conductive sheet according to the present embodiment.
[FIG. 3B] FIG. 3B is a schematic cross-sectional view showing another example of the thermally-conductive sheet according to the present embodiment.
[FIG. 3C] FIG. 3C is a schematic cross-sectional view showing another example of the thermally-conductive sheet according to the present embodiment.
[FIG. 3D] FIG. 3D is a schematic cross-sectional view showing an example of a thermally-conductive sheet according to a comparative embodiment.
[FIG. 3E] FIG. 3E is a schematic cross-sectional view showing an example of a thermally-conductive sheet according to a comparative embodiment.
[FIG. 4A] FIG. 4A is a schematic cross-sectional view showing another example of the thermally-conductive sheet according to the present embodiment.
[FIG. 4B] FIG. 4B is a schematic cross-sectional view showing another example of the thermally-conductive sheet according to the present embodiment.
[FIG. 4C] FIG. 4C is a schematic cross-sectional view showing another example of the thermally-conductive sheet according to the present embodiment.
[FIG. 4D] FIG. 4D is a schematic cross-sectional view showing another example of the thermally-conductive sheet according to the present embodiment.
[FIG. 4E] FIG. 4E is a schematic cross-sectional view showing another example of the thermally-conductive sheet according to the present embodiment.
[FIG. 5A] FIG. 5A is a schematic cross-sectional view showing another example of the thermally-conductive sheet according to the present embodiment.
[FIG. 5B] FIG. 5B is a schematic cross-sectional view showing another example of the thermally-conductive sheet according to the present embodiment.
[FIG. 5C] FIG. 5C is a schematic cross-sectional view showing another example of the thermally-conductive sheet according to the present embodiment.
[FIG. 5D] FIG. 5D is a schematic cross-sectional view showing another example of the thermally-conductive sheet according to the present embodiment.
[FIG. 5E] FIG. 5E is a schematic cross-sectional view showing another example of the thermally-conductive sheet according to the present embodiment.
[FIG. 5F] FIG. 5F is a schematic cross-sectional view showing another example of the thermally-conductive sheet according to the present embodiment.
[FIG. 6A] FIG. 6A is a schematic cross-sectional view showing an example of a process of a thermally-conductive sheet production method according to the present embodiment (part 1).
[FIG. 6B] FIG. 6B is a schematic cross-sectional view showing an example of the process of the thermally-conductive sheet production method according to the present embodiment (part 2).
[FIG. 6C] FIG. 6C is a schematic cross-sectional view showing an example of the process of the thermally-conductive sheet production method according to the present embodiment (part 3).
[FIG. 6D] FIG. 6D is a schematic cross-sectional view showing an example of the process of the thermally-conductive sheet production method according to the present embodiment (part 4).
[FIG. 6E] FIG. 6E is a schematic cross-sectional view showing an example of the process of the thermally-conductive sheet production method according to the present embodiment (part 5).
[FIG. 6F] FIG. 6F is a schematic cross-sectional view showing an example of the process of the thermally-conductive sheet production method according to the present embodiment (part 6).
[FIG. 7A] FIG. 7A is a schematic cross-sectional view showing another example of the process of the thermally-conductive sheet production method according to the present embodiment (part 1).
[FIG. 7B] FIG. 7B is a schematic cross-sectional view showing another example of the process of the thermally-conductive sheet production method according to the present embodiment (part 2).
[FIG. 7C] FIG. 7C is a schematic cross-sectional view showing another example of the process of the thermally-conductive sheet production method according to the present embodiment (part 3).
[FIG. 8] FIG. 8 is a schematic cross-sectional view showing an example of a heat dissipation structure according to the present embodiment.

### DETAILED DESCRIPTION OF THE INVENTION

### (Thermally-Conductive Sheet)

A thermally-conductive sheet of the present invention is a thermally-conductive sheet including: a metal part including a metal layer and a metal projection on at least a first surface of the metal layer; and an adhesive part on the first surface.

The area ratio of the metal projection exposed on the first surface of the thermally-conductive sheet to the first surface is 20% or greater and 80% or less, and the ratio (Tₘ/T_{M}) of the average thickness (Tₘ) of the metal projection to the average thickness (T_{M}) of the metal layer is 0.125 or greater and 8 or less.

It is preferable that the thermally-conductive sheet is a thermally-conductive sheet further including a metal projection and an adhesive part on a second surface of the metal layer opposite to the first surface. Here, the area ratio of the metal projection exposed on the second surface of the thermally-conductive sheet to the second surface is 20% or greater and 80% or less.

In the thermally-conductive sheet according to the present embodiment, the metal part that is continuous in the thickness direction and in the planar direction of the thermally-conductive sheet, and the ratio (Tₘ/T_{M}) of the average thickness (Tₘ) of the metal projection to the average thickness (T_{M}) of the metal layer that is 8 or less provide the thermally-conductive sheet with thermal conductivity not only in the thickness direction but also in the planar direction, leading to excellent thermal conductivity. In addition, the adhesive part on at least the first surface, the area ratio of the metal projection exposed on the first surface of the thermally-conductive sheet to the first surface that is 20% or greater and 80% or less, and the ratio (Tₘ/T_{M}) of the average thickness (Tₘ) of the metal projection to the average thickness (T_{M}) of the metal layer that is 0.125 or greater can reduce: lifting or delamination of the thermally-conductive sheet from base materials of a heating element, a heat dissipation member, and the like; and occurrence of voids in a laminate in which the thermally-conductive sheet is provided between the base materials, leading to excellent adhesiveness with the base materials and excellent reliability. Therefore, by providing the thermally-conductive sheet between the heating element and the heat dissipation member, it is possible to dissipate heat generated from the heating element efficiently via the thermally-conductive sheet, and it is possible to provide a thermally-conductive sheet that can achieve both high thermal conductivity and reliability.

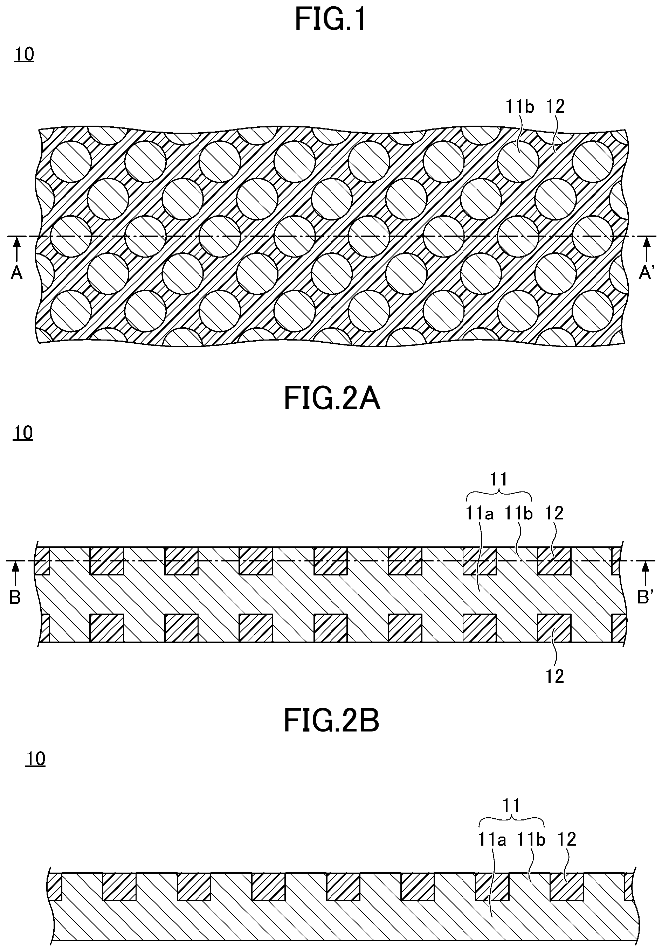

FIG. 1 and FIG. 2A are a schematic cross-sectional view showing an example of the thermally-conductive sheet according to the present embodiment, and a schematic cross-sectional view taken along an A-A' cross-section thereof. FIG. 1 is a schematic cross-sectional view taken along a B-B' cross-section of FIG. 2A.

A thermally-conductive sheet 10 shown in FIG. 1 and FIG. 2A includes a metal part 11 and an adhesive part 12, and includes metal projections 11b and adhesive parts 12 on both surfaces of the thermally-conductive sheet 10. The metal part 11 includes a metal layer 11a and a plurality of metal projections 11b on each of the first surface of the metal layer 11a and the second surface of the metal layer 11a opposite to the first surface. The thermally-conductive sheet 10 includes the adhesive parts 12 that are filled at locations other than the locations at which the metal projections 11b are provided on the first surface and the second surface of the metal layer 11. As shown in the cross-sectional view of FIG. 1, a pattern of the metal projections 11b and the adhesive parts 12 is formed. The thermally-conductive sheet 10 has a pattern of the metal projections 11b and the adhesive parts 12 on the first surface and the second surface (respective exposed surfaces) in a pattern similar to that in the cross-sectional view of FIG. 1. The area ratio of the metal projections 11b exposed on the first surface of the thermally-conductive sheet 10 to the first surface is 20% or greater and 80% or less, and the area ratio of the metal projections 11b exposed on the second surface of the thermally-conductive sheet 10 to the second surface is 20% or greater and 80% or less. The ratio (Tₘ/T_{M}) of the average thickness (Tₘ) of the metal projections 11b to the average thickness (T_{M}) of the metal layer 11a on each of the first surface and the second surface of the thermally-conductive sheet 10 is 0.125 or greater and 8 or less.

As FIG. 2B shows in an A-A' cross-sectional view of another example of the thermally-conductive sheet according to the present embodiment, the thermally-conductive sheet 10 may include the metal projections 11b and the adhesive parts 12 on the first surface (only one surface).

The thermally-conductive sheet 10 shown in FIG. 2B includes a metal part 11 and adhesive parts 12. The metal part 11 includes a metal layer 11a and a plurality of metal projections 11b on the first surface of the metal layer 11a. The thermally-conductive sheet 10 includes the adhesive parts 12 filled at locations other than the locations at which the metal projections 11b are provided on the first surface of the metal layer 11a. The pattern of the metal projections 11b and the adhesive parts 12 on a planar cross-section and on the exposed surface of the thermally-conductive sheet 10 of FIG. 2B is similar to that shown in the cross-sectional view of FIG. 1. The area ratio of the metal projections 11b exposed on the first surface of the thermally-conductive sheet 10 to the first surface is 20% or greater and 80% or less. Further, the ratio (Tₘ/T_{M}) of the average thickness (Tₘ) of the metal projections 11b to the average thickness (T_{M}) of the metal layer 11a is 0.125 or greater and 8 or less.

### <Metal Part>

The metal part includes the metal layer and the metal projections on at least the first surface of the metal layer. It is preferable that the metal part includes the metal projections on each of the first surface and the second surface of the metal layer.

As will be described later regarding a thermally-conductive sheet production method, the metal part may be formed by imparting the metal projections to the metal layer by plating and the like, or may be formed by carving out the metal projections from a metal plate by processing the metal plate by etching and the like.

### <<Metal Layer>>

It is preferable that the material of the metal layer contains a metal having high thermal conductivity, and more preferable that the material is composed of the metal.

From the viewpoint of thermal conductivity and safety, the metal is preferably aluminum, nickel, iron, gold, silver, copper, zinc, and tin, and more preferably gold, silver, copper, aluminum, and nickel.

The thermal conductivity of the metal layer is not particularly limited, can be appropriately selected in accordance with the purpose, yet from the viewpoint of thermal conductivity, is preferably 50 W/(m·K) or greater, and more preferably 100 W/(m·K) or greater.

The thermal conductivity of the metal is not particularly limited and can be appropriately selected in accordance with the purpose, yet from the viewpoint of thermal conductivity, is preferably 50 W/(m·K) or greater, more preferably 100 W/(m·K) or greater, and even more preferably 200 W/(m·K) or greater.

### <<Metal Projections>>

The metal projections are not particularly limited and can be appropriately selected in accordance with the purpose. Examples of the metal projections include: metal formed by plating, such as electrolytic plating, non-electrolytic plating, and the like; a product filled with a metal material and, if necessary, a filler; a product composed of the same material as the metal layer, carved out from a metal plate; and the like.

Among these, metal formed by electrolytic plating is preferable.

The metal formed by electrolytic plating is not particularly limited, and can be suitably selected from the metals specified above in accordance with the purpose.

The metal projections may be a product filled with a metal material, or may be a product filled with a mixture of a metal material and a filler as an optional component.

The type of the metal material is not particularly limited and can be appropriately selected in accordance with the purpose, yet from the viewpoint of thermal conductivity and safety, is preferably aluminum, aluminum oxide, aluminum nitride, boron nitride, carbon resin, nickel, iron, gold, silver, copper, zinc, and tin, and is more preferably gold, silver, copper, and nickel.

One of these may be used alone, or two or more of these may be used in combination.

The shape of the metal material is not particularly limited and can be appropriately selected in accordance with the purpose, and examples of the shape include a particulate shape, a plate shape, a wire shape, and the like.

From the viewpoint of thermal conductivity, the content of the metal material in the metal projections is preferably 50% by mass or greater, more preferably any one of 60% by mass or greater, 70% by mass or greater, or 80% by mass or greater, even more preferably 90% by mass or greater, particularly preferably 95% by mass or greater, and most preferably 99% by mass or greater.

The filler is not particularly limited and can be appropriately selected in accordance with the purpose, and examples of the filler include a dispersant, a surfactant, a binder resin, and the like.

### <<Adhesive Parts>>

The adhesive parts are not particularly limited as long as they have adhesiveness and can be suitably selected in accordance with the purpose, yet are preferably a resin having adhesiveness.

It is preferable that the resin is a product obtained by polymerizing a composition containing a curing component and a curing agent, and further containing, if necessary, other components, such as a metal filler and the like.

### -Resin-

The resin is not particularly limited, can be suitably selected in accordance with the purpose, yet is preferably a modified acrylate compound, an epoxy resin, an unsaturated polyester resin, a polyurethane resin, a bismaleimide resin, an alkyd resin, a phenol resin, and a melamine resin. One of these may be used alone, or two or more of these may be used in combination.

### -Curing Component-

As the curing component, it is preferable to use at least one of an oxirane ring compound or an oxetane compound.

The oxirane ring compound is a compound having an oxirane ring, and examples of the oxirane ring compound include an epoxy resin.

The epoxy resin is not particularly limited and can be appropriately selected in accordance with the purpose, and examples of the epoxy resin include a glycidyl ether-type epoxy resin, a phenol novolac-type epoxy resin, a cresol novolac-type epoxy resin, a bisphenol A-type epoxy resin, a trisphenol-type epoxy resin, a tetraphenol-type epoxy resin, a phenol-xylylene-type epoxy resin, a naphthol-xylylene-type epoxy resin, a phenol-naphthol-type epoxy resin, a phenol-dicyclopentadiene-type epoxy resin, an alicyclic epoxy resin, an aliphatic epoxy resin, and the like.

One of these may be used alone, or two or more of these may be used in combination.

### -Curing Agent-

The curing agent is a curing agent suited to the curing component, and examples of the curing agent include: a polyfunctional carboxylic acid; an acid anhydride-based curing agent; an aliphatic amine-based curing agent; an aromatic amine-based curing agent (for example, imidazole-based curing agent); a phenol-based curing agent; a polyaddition-type curing agent, such as a mercaptan-based curing agent and the like; a catalyst-type curing agent, such as an imidazole and the like; and the like.

One of these may be used alone, or two or more of these may be used in combination.

Among these, an aromatic amine-based curing agent is preferable, and an imidazole-based curing agent is more preferable.

### -Metal Filler-

The adhesive parts may further contain a metal filler.

The metal filler is preferably at least any one of copper particles, silver-coated particles, or silver particles, and is more preferably silver particles.

Examples of the silver-coated particles include silver-coated copper particles, silver-coated nickel particles, silver-coated aluminum particles, and the like.

The shape of the metal filler is not particularly limited and can be suitably selected in accordance with the purpose. Examples of the shape include a spherical shape, a flat shape, a particulate shape, an acicular shape, and the like.

When the adhesive parts contain the metal filler, the content of the metal filler in the adhesive parts is not particularly limited, can be suitably selected in accordance with the purpose, yet from the viewpoint of improving the thermal conductivity without impairing the adhesiveness of the adhesive parts, is preferably greater than 0% by volume and 90% by volume or less, more preferably 40% by volume or greater and 80% by volume or less, and even more preferably 50% by volume or greater and 70% by volume or less.

The volume average particle diameter of the metal filler is preferably 0.3 µm or greater and 30 µm or less, and more preferably 0.5 µm or greater and 10 µm or less.

The volume average particle diameter can be measured by, for example, a laser diffraction/scattering particle size analyzer (Microtrac MT3300EXII).

### [Area Ratio]

On the first surface (exposed surface) of the thermally-conductive sheet, the area ratio of the metal projections exposed on the first surface of the thermally-conductive sheet to the first surface is 20% or greater and 80% or less, and preferably 30% or greater and 70% or less, because it is possible to reduce: lifting or delamination of the thermally-conductive sheet from a base material; and occurrence of voids, leading to excellent adhesiveness with the base material, and excellent reliability.

### [Pattern]

The pattern of the metal projections 11b and the adhesive parts 12 is not particularly limited as long as it satisfies the area ratio specified above, and can be appropriately selected in accordance with the purpose. Examples of the pattern include patterns in which a plurality of figures are arranged.

Among these patterns, a pattern in which a plurality of figures are regularly arranged is preferable from the viewpoint of uniformity of thermal conductivity. Further, from the viewpoint of improvement of adhesiveness, a pattern in which the adhesive parts are continuous in the planar direction is more preferable. From the viewpoint of improvement of thermal conductivity, a pattern in which the metal projections are continuous in the planar direction is more preferable. Alternatively, a pattern in which both the metal projections and the adhesive parts are continuous in the planar direction, as in a comb-shaped electrode, may be employed. In any case, appropriate selections may be made in accordance with the intended form.

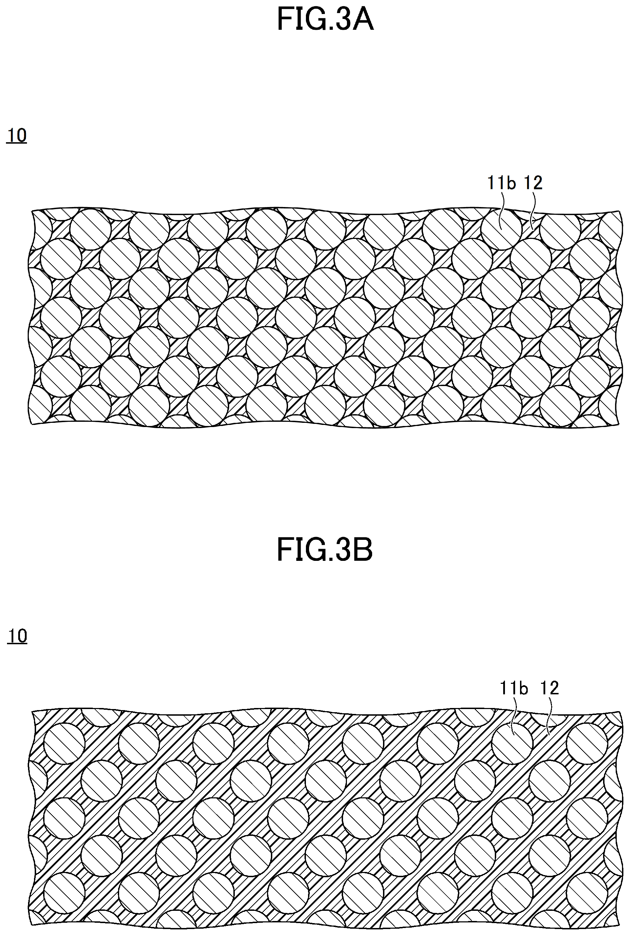

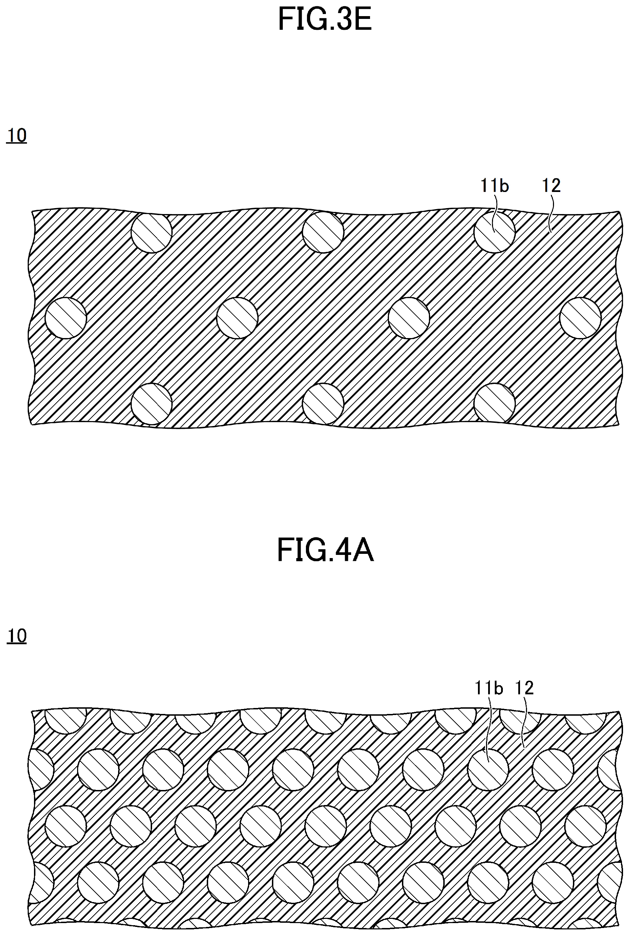

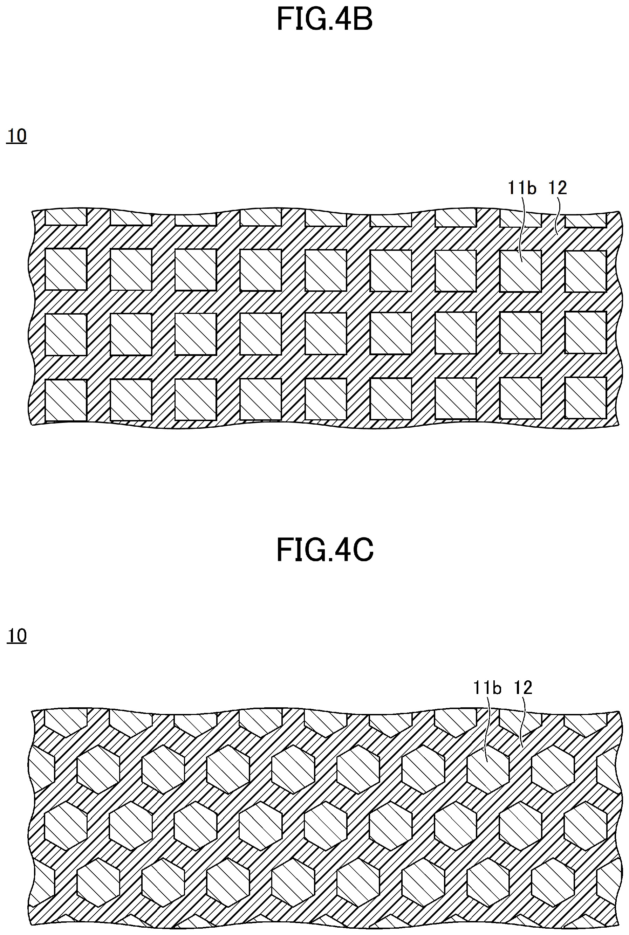

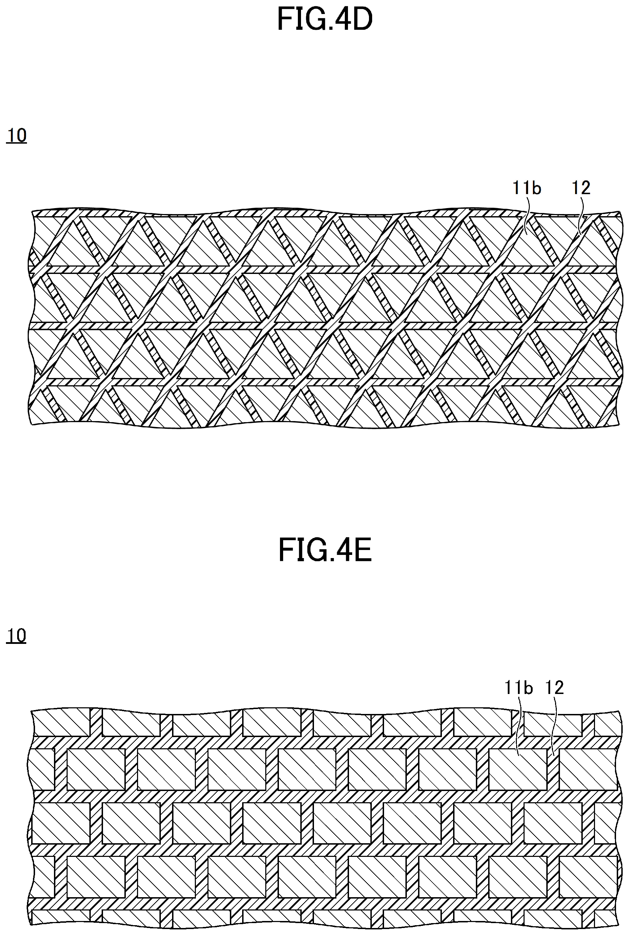

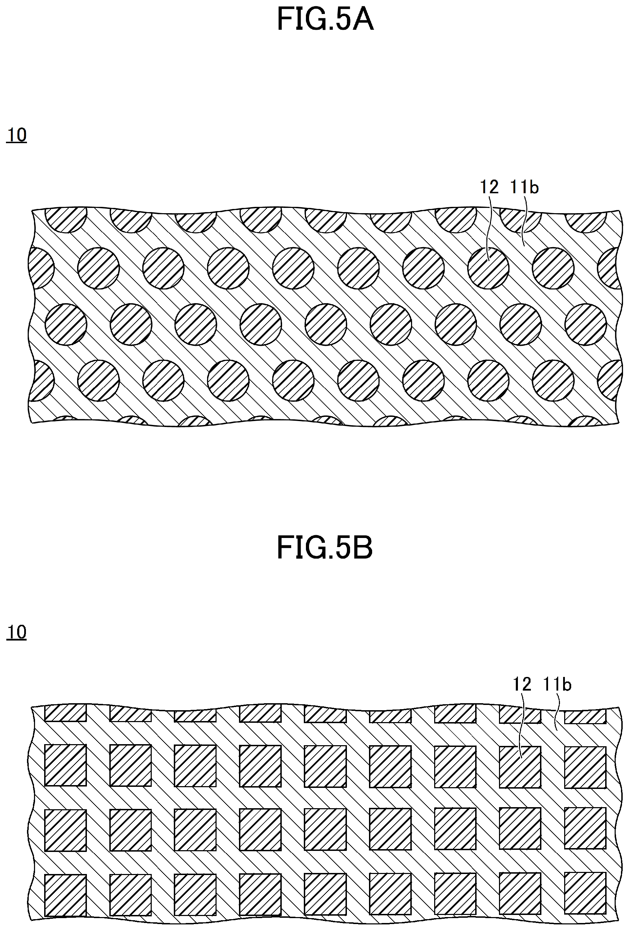

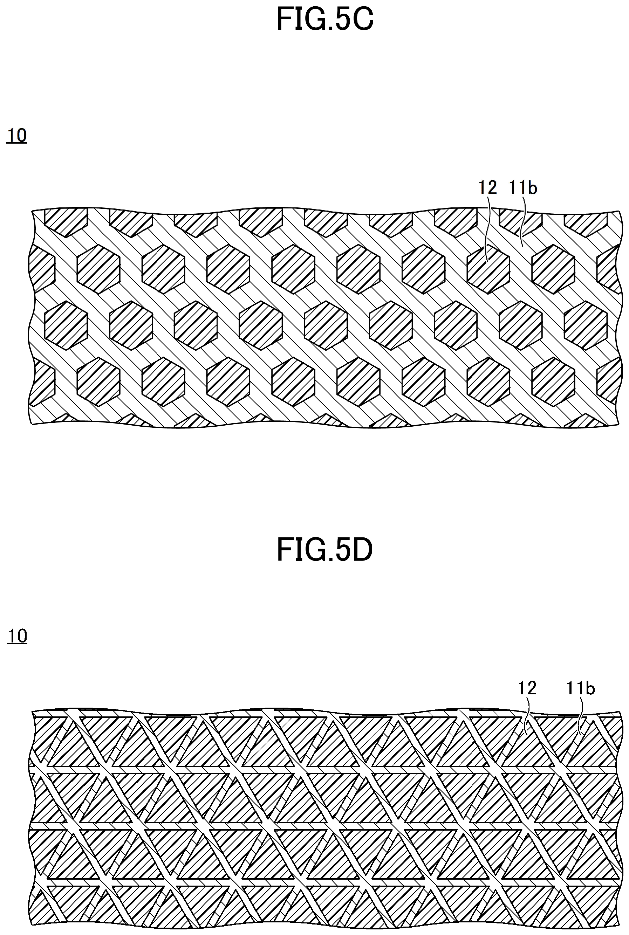

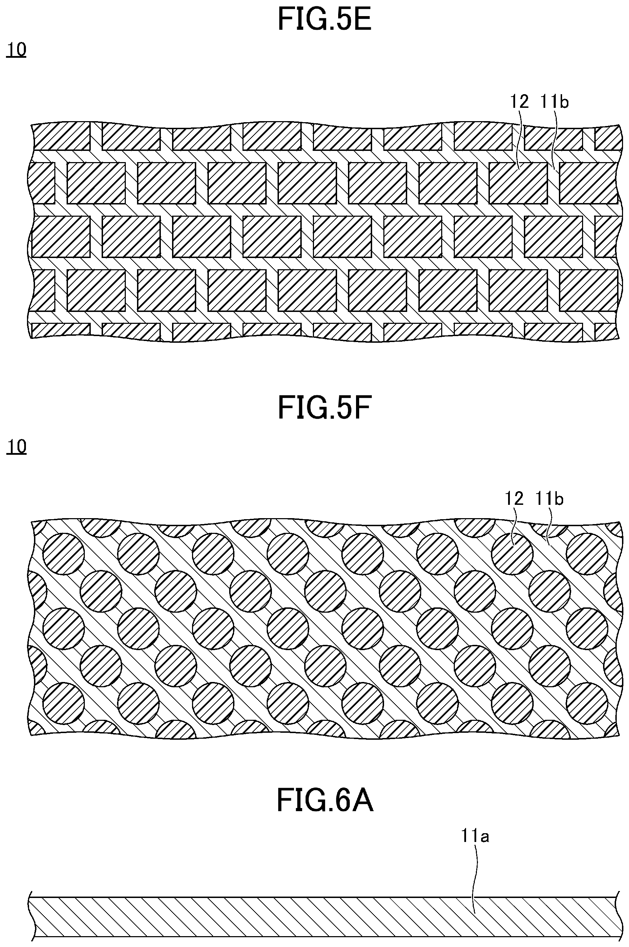

Examples of the pattern include patterns of 45° zigzags (FIGS. 3A to 3C and FIG. 5F), 60° zigzags (FIG. 4A and FIG. 5A), aligned squares (FIG. 4B and FIG. 5B), 60° zigzag-arranged regular hexagons (FIG. 4C and FIG. 5C), regular triangles (FIG. 4D and FIG. 5D), staggered rectangles (FIG. 4E and FIG. 5E), and the like, which will be described later.

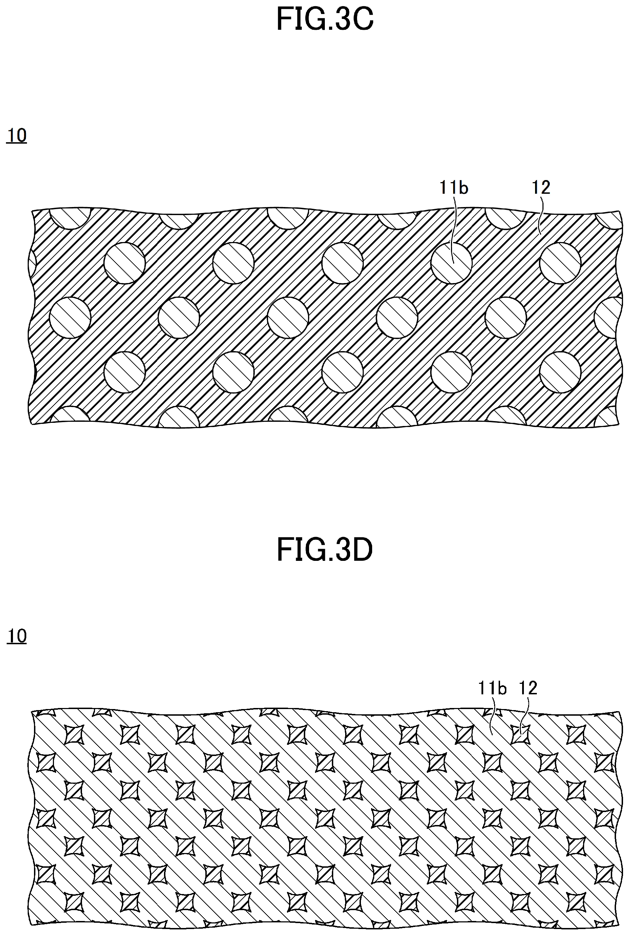

Referring to FIGS. 3A to 3E, the pattern and the area ratio of the metal projections 11b and the adhesive parts 12 will be described. FIGS. 3A to 3C are schematic cross-sectional views showing another example of the thermally-conductive sheet according to the present embodiment. FIGS. 3D and 3E are schematic cross-sectional views showing an example of a thermally-conductive sheet according to a comparative embodiment. Although these are cross-sectional views of the thermally-conductive sheets in the planar direction, the pattern on the exposed surface of the thermally-conductive sheets is also the same.

The patterns shown in FIGS. 3A to 3E are patterns in which a plurality of circular metal projections 11b are arranged in directions that are at 45° with respect to each other (a pattern of 45° zigzags, referred to as "45° zigzags"). It is possible to adjust the area ratio by appropriately adjusting the distance between the plurality of circles (e.g., the distance between the centers of adjacent circles).

In the patterns shown in FIGS. 3A to 3E, the ratio, expressed as metal projections : adhesive part (area ratio), is 80:20, 50:50, 20:80, 90:10, and 10:90, respectively, which are, when expressed as the area ratio focusing on the metal projections, 80%, 50%, 20%, 90%, and 10%.

The embodiments shown in FIGS. 3A to 3C in which the area ratio is in the range of 20% or greater and 80% or less correspond to Examples 1 to 3 (and Examples 4 to 6) among Examples described later. The comparative embodiments shown in FIGS. 3D and 3E in which the area ratio is outside the range of 20% or greater and 80% or less correspond to Comparative Examples 1 and 2 among Examples described later.

Variations of the pattern of the metal projections 11b and the adhesive parts 12 will be described with reference to FIGS. 4A to 4E. FIGS. 4A to 4E are schematic cross-sectional views showing another example of the thermally-conductive sheet according to the present embodiment.

The pattern shown in FIG. 4A is a pattern in which a plurality of circular metal projections 11b are arranged in directions that are at 60° with respect to each other (referred to as "60° zigzags"). The pattern shown in FIG. 4B is a pattern in which a plurality of square metal projections 11b are aligned with each other (arranged in directions that are at 90°) (referred to as "aligned squares"). The pattern shown in FIG. 4C is a pattern in which a plurality of regular hexagonal metal projections 11b are arranged in directions that are at 60° with respect to each other (referred to as "60° zigzag-arranged regular hexagons"). The pattern shown in FIG. 4D is a pattern in which a plurality of regular triangular metal projections 11b are arranged in directions that are at 60° with respect to each other (referred to as "regular triangles"). The pattern shown in FIG. 4E is a pattern in which a plurality of rectangular metal projections 11b are arranged in a staggered manner, that is, they are arranged shifted by 1/2 the length of their longer side in the longer-side direction of the rectangles (referred to as "staggered rectangles").

It is possible to adjust the area ratio of the metal projections in the same manner as in the case of the 45° zigzags (FIGS. 3A to 3C). Specifically, it is possible to adjust the area ratio by appropriately adjusting the distance between the plurality of figures (e.g., the distance between the centers of adjacent figures).

Although patterns in which the metal projections 11b are arranged as a plurality of figures have been described above, patterns in which the metal projections 11b and the adhesive parts 12 are positionally interchanged and the adhesive parts 12 are arranged as a plurality of figures can also be suitably employed.

FIGS. 5A to 5E and FIG. 5F are schematic cross-sectional views showing another example of the thermally-conductive sheet according to the present embodiment, and are the same as FIGS. 4A to 4E and FIG. 3B, respectively, except that the metal projections 11b and the adhesive parts 12 are positionally interchanged from FIGS. 4A to 4E and FIG. 3B.

The size of the figures of the metal projections 11b in the patterns is not particularly limited and can be appropriately selected in accordance with the purpose. Yet, the length of the longer side of the figures is preferably 10 µm or greater and 1,000 µm or less, and more preferably 50 µm or greater and 500 µm or less.

The thermal conductivity of the thermally-conductive sheet is not particularly limited and can be appropriately selected in accordance with the purpose, yet from the viewpoint of thermal conductive properties, is preferably 20 W/(m·K) or greater, more preferably 30 W/(m·K) or greater, and even more preferably 50 W/(m·K) or greater.

The average thickness of the thermally-conductive sheet is not particularly limited and can be appropriately selected in accordance with the purpose, yet is preferably 0.2 µm or greater 100 µm or less, more preferably 1 µm or greater and 50 µm or less, and even more preferably 5 µm or greater and 30 µm or less.

The average thickness of the metal layer is not particularly limited and can be appropriately selected in accordance with the purpose, yet is preferably 0.1 µm or greater and 50 µm or less, more preferably 0.5 µm or greater and 25 µm or less, and even more preferably 2.5 µm or greater and 20 µm or less.

The ratio (Tₘ/T_{M}) of the average thickness (Tₘ) of the metal projections to the average thickness (T_{M}) of the metal layer is not particularly limited and can be appropriately selected in accordance with the purpose, yet is 0.125 or greater and 8 or less, and from the viewpoint of further improvement of thermal conductivity and reliability, is preferably 0.2 or greater and 4 or less, and more preferably 0.5 or greater and 2 or less.

When the thermally-conductive sheet includes the metal projections on both the first surface and the second surface, the ratio (Tₘ/T_{M}) can be set independently for the metal projections on each surface. The ratio (Tₘ/T_{M}) on the first surface and the ratio (Tₘ/T_{M}) on the second surface may be different or the same.

It is possible to suitably produce a thermally-conductive sheet having the desired area ratio and the desired ratio (Tₘ/T_{M}), by producing the thermally-conductive sheet by a thermally-conductive sheet production method described later. In addition, it is possible to fill the gaps between the metal projections with the adhesive parts without any vacant parts.

On the other hand, if any vacant parts remain in the thermally-conductive sheet to generate voids (also referred to as cells), the thermally-conductive sheet might get heated due to heat conduction from a heating element, which might impair the reliability of the thermally-conductive sheet due to expansion and bursting of the voids (cells), generation of cracks, and the like.

Further, since the voids (cells) have high heat-insulating properties, the thermal conductivity of the thermally-conductive sheet to be obtained might be reduced.

Further, in a laminate in which the thermally-conductive sheet is provided between base materials of a heating element, a heat dissipation member, and the like, lifting or delamination of the thermally-conductive sheet from the base materials, or generation of voids, which might occur, would reduce the adhesiveness with the base materials and might impair the reliability of the thermally-conductive sheet.

Examples of the method for confirming the reliability of the thermally-conductive sheet include: a method of evaluating presence or absence of voids in the thermally-conductive sheet by using a Scanning Acoustic Tomograph (SAT), for a laminate after being pressure-bonded; a method of evaluating adhesiveness with the base materials and presence or absence of voids by using a Scanning Acoustic Tomograph (SAT), for a laminate after being pressure-bonded after an accelerated life test (for example, 192 hours at 130°C at a humidity of 85%); a method of indirectly estimating adhesiveness with the base materials and presence or absence of voids by comparing the thermal conductivity of the produced thermally-conductive sheet with the thermal conductivity of the metal layer used, as a ratio (%); combinations of these methods; and the like.

The thermally-conductive sheet, which has the adhesive parts exposed on the surface thereof, exhibits excellent adhesiveness and can inhibit generation of vacant parts when, for example, adhesively joined with another member, such as a heating element, a heat dissipation member, and the like. Therefore, the thermally-conductive sheet has excellent reliability after a heating treatment (accelerated life test) as well.

The thermally-conductive sheet, which includes the metal part that is continuous in the thickness direction and the planar direction of the thermally-conductive sheet, can relax stress. In addition, the thermally-conductive sheet, which overcomes the problem that the film itself becomes brittle and collapses through a high-temperature test and the like, as observed in a thermally-conductive sheet obtained by binding a thermally-conductive material with a binder resin, can suitably avoid collapse.

### (Thermally-Conductive Sheet Production Method)

A thermally-conductive sheet production method of the present invention is not particularly limited, and can be appropriately selected in accordance with the purpose. Examples include: a method of forming the metal projections and the adhesive parts on the metal layer (first embodiment); a method of carving out the metal part in which the metal layer and the metal projections are integrated, by etching a metal plate (second embodiment); a method of pasting a layer including the metal projections and the adhesive parts that are formed in advance, and the metal layer to each other (third embodiment).

### [First Embodiment]

The thermally-conductive sheet production method according to the first embodiment includes a protective part applying step and a metal projection forming step, preferably includes a protective part removing step and an adhesive part filling step, and further includes other steps, such as a polishing step and the like, as necessary.

By the thermally-conductive sheet production method according to the first embodiment, the above-described thermally-conductive sheet of the present invention can be suitably produced.

FIGS. 6A to 6F are schematic cross-sectional views showing an example of the process of the thermally-conductive sheet production method according to the first embodiment. In the present embodiment, the metal projections are formed on the first surface and the second surface (both surfaces) of the metal layer.

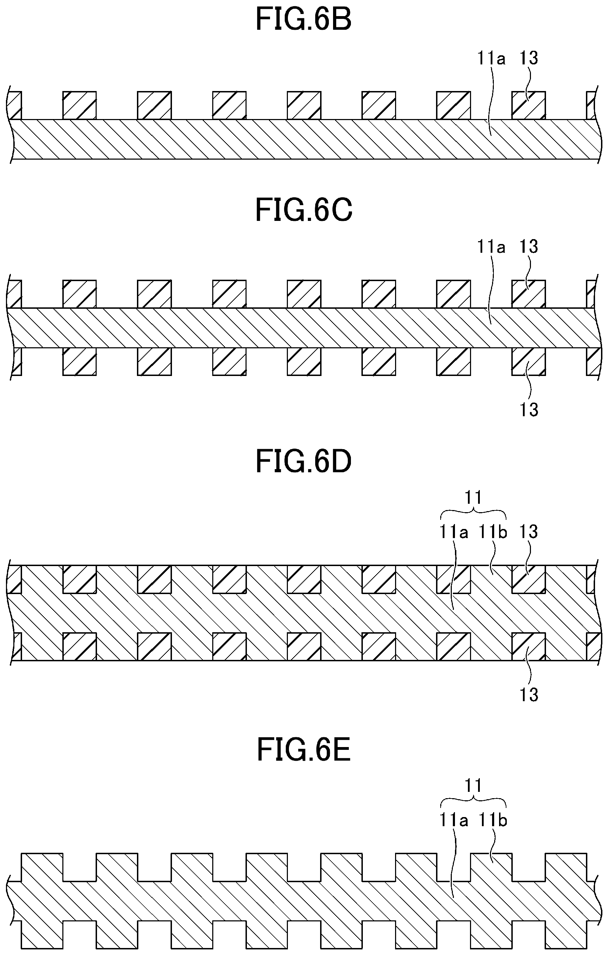

First, a metal layer 11a is prepared (FIG. 6A), protective parts 13 are formed on the first surface of the metal layer 11a (FIG. 6B, protective part applying step), and optionally, the protective parts 13 are also formed on the second surface of the metal layer 11a (FIG. 6C). Next, the metal projections 11b are formed on the exposed surface of the metal layer 11a on which no protective parts 13 are applied (FIG. 6D, metal projection forming step). When the protective parts 13 are the adhesive parts 12, this completes production of the thermally-conductive sheet 10.

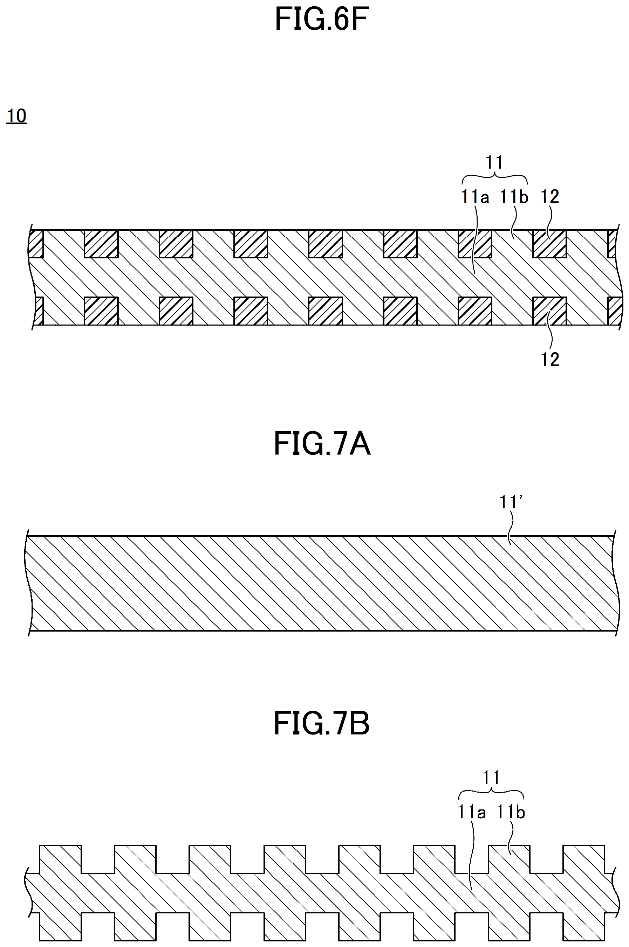

When the protective parts 13 are not the adhesive parts 12, the protective parts 13 are removed (FIG. 6E, protective part removing step), to obtain the metal part 11 including: the metal layer 11a; and the metal projections 11b on the first surface and the second surface of the metal layer 11a. Next, the adhesive parts 12 are filled on the exposed surface of the metal layer 11a from which the protective parts 13 have been removed (FIG. 6F, adhesive part filling step). Thus, the thermally-conductive sheet 10 including: the metal part 11 including the metal layer 11a and the metal projections 11b on the first surface and the second surface of the metal layer 11a; and the adhesive parts 12 on the first surface and the second surface of the metal layer 11a can be produced.

Each step will be described in detail below.

### <Protective Part Applying Step>

The protective part applying step is a step of applying the protective parts to at least the first surface of the metal layer, and can be suitably performed by a protective part applying member.

In a case of producing a thermally-conductive sheet including the metal projections and the adhesive parts on both surfaces thereof, the protective part applying step is a step of applying the protective parts to the first surface and the second surface of the metal layer.

The pattern of the protective parts applied in the protective part applying step may be the same as the pattern of the adhesive parts in the intended thermally-conductive sheet.

The protective parts may be the adhesive parts or members different from the adhesive parts, and can be suitably selected in accordance with the intended mode.

The method for applying the protective parts is not particularly limited, and can be appropriately selected in accordance with the purpose. Examples include: a method of applying the protective parts having a desired pattern by imprinting; a method of applying the protective parts having a desired pattern by inkjet printing, screen printing, and the like; a method of forming the protective parts having a desired pattern by a resist; and the like.

Examples of the method of forming the protective parts having a desired pattern by a resist include a method of forming the protective parts by applying a resist to at least the first surface of the metal layer, exposing the first surface to light desired-pattern-wise and developing the desired pattern, and heating the resulting product after the exposure or the development as necessary. The resist may be a negative type that keeps the exposed parts in place through the development, or a positive type that keeps the unexposed parts in place through the development.

### <Metal Projection Forming Step>

The metal projection forming step is a step of forming the metal projections on the exposed surface of the metal layer to which no protective parts are applied, and can be suitably performed by a metal projection forming member.

The method for forming the metal projections is not particularly limited, and can be suitably selected in accordance with the purpose. Examples include: a method of forming the metal projections by plating, such as electrolytic plating, non-electrolytic plating, and the like; a method of forming the metal projections by filling a composition containing a metal material; a method of forming the metal projections by sputtering or evaporation; and the like. According to these methods, a process may be performed a single time, a process may be performed a plurality of times, or a plurality of processes may be performed in combination.

Regarding the particulars, such as the metal, the metal material, and the filler in the metal projections, and the like, the particulars described above regarding the metal projections of the thermally-conductive sheet of the present invention may be selected appropriately.

The plating may be either electrolytic plating or electroless plating (chemical plating). Yet, electrolytic plating is preferred from the viewpoint of throughput.

The metal to be filled by the plating is not particularly limited and can be suitably selected in accordance with the purpose. Yet, it is preferable that the metal contains at least any one of nickel, gold, silver, or copper, and more preferably is at least any one of nickel, gold, silver, or copper.

The composition containing the metal material contains the metal material and, if necessary, a filler and a solvent.

The content of the metal material in the composition is preferably 50% by mass or greater, more preferably any one of 60% by mass or greater, 70% by mass or greater, or 80% by mass or greater, even more preferably 90% by mass or greater, and particularly preferably 95% by mass or greater relative to the solid content in the composition.

The solvent is not particularly limited and may be suitably selected in accordance with the purpose, and examples of the solvent include terpineol, butyl carbitol, butyl carbitol acetate, texanol, and the like.

The composition may be prepared by mixing and dispersing the metal material and, if necessary, the filler and the solvent.

A commercially available product may be used as the composition. Examples of the commercially available product as a metal paste containing metal particles include H 9890-6A (a thermosetting conductive adhesive silver paste, available from NAMICS Corporation), and the like.

The method for filling the vacant parts for the metal projections in the metal part with the composition is not particularly limited, and can be appropriately selected in accordance with the purpose. Examples of the method include a dipping method, an inkjet method, a dispensing method, a spray coating method, a slit coating method, a spin coating method, and the like.

When the protective parts are the adhesive parts, the thermally-conductive sheet can be suitably produced by the protective part applying step and the metal projection forming step. Further, if necessary, other steps, such as a polishing step and the like, may be provided.

When the protective parts are not the adhesive parts, it is preferable to further provide the protective part removing step and the adhesive part filling step in addition to the protective part applying step and the metal projection forming step. Further, if necessary, other steps, such as a polishing step and the like, may be provided.

### <Protective Part Removing Step>

The protective part removing step is a step of removing the protective parts, and can be suitably performed by a protective part removing member.

The method for removing the protective parts is not particularly limited and can be suitably selected in accordance with the purpose. Examples include a method of removing the adhesive parts by a treatment employing high-temperature heating, a strong alkali, an organic solvent, and the like.

### <Adhesive Part Filling Step>

The adhesive part filling step is a step of filling the adhesive parts on the exposed surface of the metal layer from which the protective parts have been removed, and can be suitably performed by an adhesive part filling member.

The method for filling the adhesive parts is not particularly limited and can be suitably selected in accordance with the purpose. Examples include a dipping method, an inkjet method, a dispensing method, a spray coating method, a slit coating method, a spin coating method, and the like.

### <Polishing Step>

The polishing step may be a step of polishing the surface of the metal layer on which the metal projections are formed, following the metal projection forming step or the protective part removing step, or a step of polishing the surface of the metal layer on which the metal projections and the adhesive parts are formed, following the metal projection forming step or the adhesive part filling step.

The method for polishing the surface of the metal layer is not particularly limited and publicly known methods can be suitably selected in accordance with the purpose.

Since the polishing step exposes the metal projections and the adhesive parts on the surface of the obtained thermally-conductive sheet, excellent adhesiveness with other members, excellent reliability as the thermally-conductive sheet, and excellent conductivity are obtained.

### [Second Embodiment]

The thermally-conductive sheet production method according to the second embodiment includes a metal part forming step and an adhesive part filling step, and further includes other steps, such as the polishing step and the like, as necessary.

The metal part forming step is a step of forming the metal part including the metal layer and the metal projections on at least the first surface of the metal layer by etching a metal plate.

The adhesive part filling step is a step of filling the adhesive parts on the exposed surface of the metal layer.

FIGS. 7A to 7C are schematic cross-sectional views showing an example of the process of the thermally-conductive sheet production method according to the second embodiment. In the present embodiment, the metal projections are formed on the first surface and the second surface (both surfaces) of the metal layer.

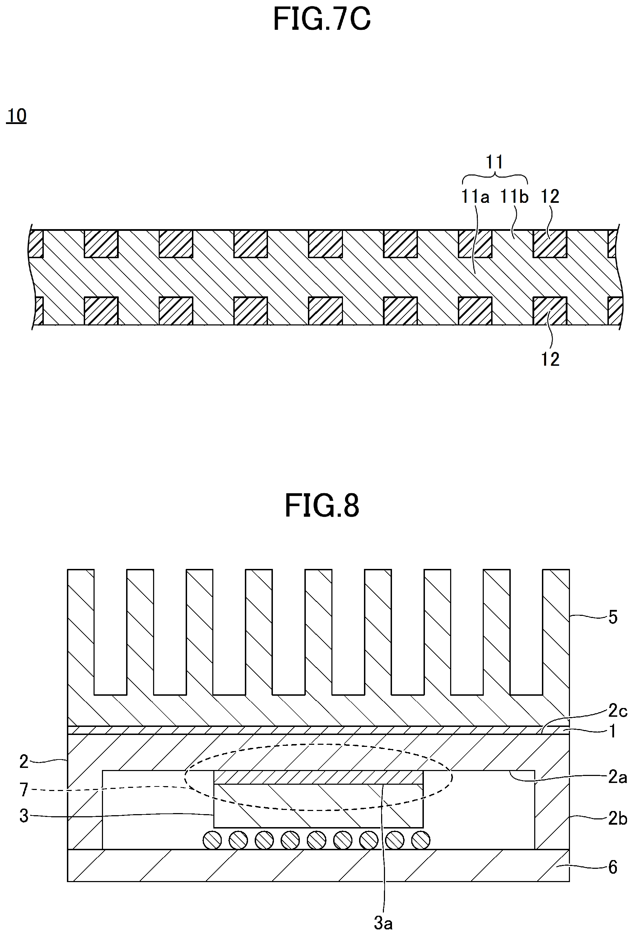

First, a metal plate 11' serving as a precursor of the metal part 11 is prepared (FIG. 7A), and regions corresponding to adhesive part 12 patterns are removed from the metal plate 11' by etching, to obtain the metal part 11 integrally including the metal layer 11a and the metal projections 11b on the first surface and the second surface of the metal layer 11a (FIG. 7B, metal part forming step). Next, the adhesive parts 12 are filled on the exposed surface of the metal layer 11a (FIG. 7C, adhesive part filling step). As a result, the thermally-conductive sheet 10 including: the metal part 11 including the metal layer 11a and the metal projections 11b on the first surface and the second surface of the metal layer 11a; and the adhesive parts 12 on the first surface and the second surface of the metal layer 11a can be produced.

### [Third Embodiment]

The thermally-conductive sheet production method according to the third embodiment preferably includes a step of forming a layer including the metal projections and the adhesive parts, and a step of pasting the obtained layer including the metal projections and the adhesive parts to a metal layer, and further includes other steps, such as the polishing step and the like, as necessary.

### (Heat Dissipation Structure)

A heat dissipation structure of the present invention includes a heating element, the above-described thermally-conductive sheet of the present invention, and a heat dissipation member, and further includes other members as necessary.

The heat dissipation structure includes the thermally-conductive sheet between the heating element and the heat dissipation member.

If necessary, the heat dissipation structure may further include an adhesive layer between the members.

The heating element is not particularly limited and can be appropriately selected in accordance with the purpose. Examples of the heating element include an electronic component, such as a Central Processing Unit (CPU), a Micro Processing Unit (MPU), a Graphics Processing Unit (GPU), and the like.

The heat dissipation member is not particularly limited as long as the heat dissipation member is a structure for dissipating heat generated by the electronic component (heating element), and can be appropriately selected in accordance with the purpose. Examples of the heat dissipation member include a heat spreader, a heat sink, a vapor chamber, a heat pipe, and the like.

The heat spreader is a member for efficiently transferring heat from the electronic component to other components. The material of the heat spreader is not particularly limited and can be appropriately selected in accordance with the purpose. Examples of the material include copper, aluminum, and the like. The heat spreader typically has a flat plate shape.

The heat sink is a member for releasing heat from the electronic component into the air. The material of the heat sink is not particularly limited and can be appropriately selected in accordance with the purpose. Examples of the material include copper, aluminum, and the like. The heat sink includes, for example, a plurality of fins. The heat sink includes, for example, a base part and a plurality of fins provided to extend in a direction that is not parallel with one surface of the base part (e.g., an orthogonal direction).

The heat spreader and the heat sink are typically solid structures including no space inside.

The vapor chamber has a hollow structure. A volatile liquid is sealed in the internal space of the hollow structure. Examples of the vapor chamber include a product obtained by forming the heat spreader as a hollow structure, a plate-like hollow structure that is like a product obtained by forming the heat sink as a hollow structure, and the like.

The heat pipe is a cylindrical, substantially cylindrical, or flat-tubular hollow structure. A volatile liquid is sealed in the internal space of the hollow structure.

FIG. 8 is a schematic cross-sectional view showing an example of a semiconductor device as a heat dissipation structure. A thermally-conductive sheet 7 of the present invention dissipates heat generated by an electronic component 3, such as a semiconductor element and the like, is fixed to a main surface 2a of a heat spreader 2 facing the electronic component 3, and is sandwiched between the electronic component 3 and the heat spreader 2, as shown in FIG. 5. A thermally-conductive sheet 1 is sandwiched between the heat spreader 2 and a heat sink 5. The thermally-conductive sheet 1 may be the thermally-conductive sheet of the present invention or any other thermally-conductive sheet.

For example, the heat spreader 2 is formed in the shape of a square plate, and has the main surface 2a facing the electronic component 3, and a side wall 2b erected along the outer periphery of the main surface 2a. The heat spreader 2 is provided with the thermally-conductive sheet 1 on the main surface 2a surrounded by the side wall 2b, and with the heat sink 5 on the other surface 2c opposite to the main surface 2a via the thermally-conductive sheet 1. The heat spreader 2 may be composed of, for example, copper or aluminum having good thermal conductivity, because the higher thermal conductivity it has, the lower thermal resistance it has and the more efficiently it absorbs the heat from the electronic component 3, such as a semiconductor element and the like.

The electronic component 3 is, for example, a semiconductor element, such as a BGA and the like, and is mounted on a wiring board 6. In the heat spreader 2, the distal end surface of the side wall 2b is also mounted on the wiring board 6, such that the electronic component 3 is surrounded by the side wall 2b with a predetermined interval therebetween.

With the thermally-conductive sheet 7 of the present invention provided on the main surface 2a of the heat spreader 2, a heat dissipation member that absorbs heat generated by the electronic component 3 and dissipates the heat via the heat sink 5 is formed.

### [Example]

Hereinafter, the present invention will be described more concretely based on Examples. However, the present invention should not be construed as being limited to the following Examples.

### (Example 1)

### <Production of Thermally-Conductive Sheet>

According to the production method shown in FIGS. 6A to 6F, a thermally-conductive sheet of Example 1 having the pattern of the metal projections and the adhesive parts shown in FIG. 3A was produced by the following procedure.

### <<Production of Metal Part>>

On both surfaces of a copper plate (size: 20 mm × 20 mm, average thickness: 18 µm, FIG. 6A) serving as a metal layer, an etching resist X-87 (obtained from Taiyo Ink Mfg. Co., Ltd.), as a coating liquid for forming the protective parts, was screen-printed on regions corresponding to the adhesive parts 12 shown in FIG. 3A to have an average thickness of 9 µm, and was heated at 100°C for 5 minutes, to thereby form the protective parts (FIGS. 6B and 6C).

In the pattern (45° zigzags) shown in FIG. 3A, the metal projections were formed in a circular shape having a diameter of 100 µm, and the area ratio of the metal projections, that is, the area ratio of the metal projections exposed on each surface of the thermally-conductive sheet to each surface of the thermally-conductive sheet, was 80%.

The metal layer on which the protective parts were formed was plated using a nickel sulfamate bath under plating conditions of 50°C, pH of 4.5, and 10 mA/cm², to form the metal projections having an average thickness of 9 µm (FIG. 6D). Subsequently, the protective parts were removed by being immersed in 3% NaOH at 40°C for 15 seconds, to thereby produce the metal part including the metal projections on both surfaces of the metal layer (FIG. 6E).

### <<Filling of Adhesive Parts and Production of Thermally-Conductive Sheet>>

An epoxy resin composition containing 25% by mass of a bisphenol F-type epoxy resin (EPICRON 830 (registered trademark), obtained from DIC Corporation), 5% by mass of 2-phenyl-4-methyl-5-hydroxymethyl imidazole (2P4MHZ-PW, obtained from by Shikoku Chemicals Corporation), and 70% by mass of a phenoxy resin (Phenototo YP-50 (registered trademark), obtained from NIPPON STEEL Chemical & Material Co., Ltd.), as a coating liquid for forming the adhesive parts, was filled on each surface of the metal layer of the obtained metal part and between the plurality of metal projections, using a comma knife bar coater (FJ-TADK104, obtained from Fuji Seiki Co., Ltd.) to have a thickness equivalent to that of the metal projections. Then, the obtained product was sandwiched between a nickel-plated copper plate (25 mm × 25 mm, average thickness: 1.00 mm) and a silicon plate (20 mm × 20 mm, average thickness: 0.76 mm), hot-pressed for 2 minutes by a mini-press under conditions including an upper plate temperature of 170°C on the copper plate side, a lower plate temperature of 170°C on the silicon plate side, and a set air pressure of 0.11 MPa (converted to a pressure of 40 psi), subjected to natural cooling, and then released, to thereby produce the thermally-conductive sheet of Example 1.

### (Example 2)

A thermally-conductive sheet of Example 2 was obtained in the same manner as in Example 1 except that, unlike in Example 1, the pattern shown in FIG. 3A was changed to the pattern shown in FIG. 3B, and the area ratio of the metal projections was changed to 50%.

### (Example 3)

A thermally-conductive sheet of Example 3 was obtained in the same manner as in Example 1 except that, unlike in Example 1, the pattern shown in FIG. 3A was changed to the pattern shown in FIG. 3C, and the area ratio of the metal projections was changed to 20%.

### (Examples 4 to 6)

Thermally-conductive sheets of Examples 4 to 6 were obtained in the same manner as in Examples 1 to 3 except that, unlike in Examples 1 to 3, the diameters of the metal projections in the patterns (45° zigzags) shown in FIGS. 3A to 3C were each changed to 500 µm from 100 µm.

### (Example 7)

A thermally-conductive sheet of Example 7 was obtained in the same manner as in Example 1 except that, unlike in Example 1, the pattern (45° zigzags) shown in FIG. 3A was changed to the pattern (60° zigzags) shown in FIG. 4A.

### (Example 8)

A thermally-conductive sheet of Example 8 was obtained in the same manner as in Example 1 except that, unlike in Example 1, the pattern (45° zigzags) shown in FIG. 3A was changed to the pattern (aligned squares) shown in FIG. 4B.

### (Example 9)

A thermally-conductive sheet of Example 9 was obtained in the same manner as in Example 1 except that, unlike in Example 1, the pattern (45° zigzags) shown in FIG. 3A was changed to the pattern (60° zigzag-arranged regular hexagons) shown in FIG. 4C.

### (Example 10)

A thermally-conductive sheet of Example 10 was obtained in the same manner as in Example 1 except that, unlike in Example 2, the diameter of the metal projections shown in FIG. 3B was changed from 100 µm to 1,000 µm.

### (Example 11)

A thermally-conductive sheet of Example 11 was obtained in the same manner as in Example 1 except that, unlike in Example 2, the average thickness T_{M} of the metal layer of 18 µm changed to 36 µm, the average thickness Tₘ of the metal projections of 9 µm was changed to 4.5 µm, and the ratio (Tₘ/T_{M}) of the average thickness Tₘ of the metal projections to the average thickness T_{M} of the metal layer was changed from 1 to 1/8.

### (Example 12)

A thermally-conductive sheet of Example 12 was obtained in the same manner as in Example 1 except that, unlike in Example 2, the average thickness T_{M} of the metal layer of 18 µm was changed to 6 µm, the average thickness Tₘ of the metal projections of 9 µm was changed to 48 µm, and the ratio (Tₘ/T_{M}) of the average thickness Tₘ of the metal projections to the average thickness T_{M} of the metal layer was changed from 1 to 8.

### (Comparative Example 1)

A thermally-conductive sheet of Comparative Example 1 was obtained in the same manner as in Example 1 except that, unlike in Example 1, the pattern shown in FIG. 3A was changed to the pattern shown in FIG. 3D, and the area ratio of the metal projections was changed to 90%.

### (Comparative Example 2)

A thermally-conductive sheet of Comparative Example 2 was obtained in the same manner as in Example 1 except that, unlike in Example 1, the pattern shown in FIG. 3A was changed to the pattern shown in FIG. 3E, and the area ratio of the metal projections was changed to 10%.

### (Comparative Examples 3 and 4)

Thermally-conductive sheets of Comparative Examples 3 and 4 were obtained in the same manner as in Example 4 except that, unlike in Example 4, the pattern shown in FIG. 3A was changed to the pattern shown in FIG. 3D or the pattern shown in FIG. 3E, and the area ratio of the metal projections was changed to 90% or 10%.

### (Comparative Example 5)

A thermally-conductive sheet of Comparative Example 5 and 6 was obtained in the same manner as in Example 1 except that, unlike in Example 1, the average thickness T_{M} of the metal layer of 18 µm was changed to 36 µm, the average thickness Tₘ of the metal projections of 9 µm was changed to 4 µm, and the ratio (Tₘ/T_{M}) of the average thickness Tₘ of the metal projections to the average thickness T_{M} of the metal layer was changed from 1 to 1/9.

### (Comparative Example 6)

A thermally-conductive sheet of Comparative Example 6 was obtained in the same manner as in Example 1 except that, unlike in Example 1, the average thickness T_{M} of the metal layer of 18 µm was changed to 6 µm, the average thickness Tₘ of the metal projections of 9 µm was changed to 54 µm, and the ratio (Tₘ/T_{M}) of the average thickness Tₘ of the metal projections to the average thickness T_{M} of the metal layer was changed from 1 to 9.

### (Comparative Example 7)

Indium (Pure Indium Heat-Spring Kit (2.00 inches × 2.00 inches, thickness: 0.004 inches), obtained from Indium Corporation) was used instead of the thermally-conductive sheet of Example 1. The indium was provided between a nickel-plated copper plate (25 mm × 25 mm, average thickness: 1.00 mm) and a silicon plate (20 mm × 20 mm, average thickness: 0.76 mm), and a shim tape (obtained from MISUMI Group Inc.) having an average thickness of 50 µm was inserted along the periphery of the indium. The resulting product was hot-pressed for 2 minutes by a mini-press under the conditions including an upper plate temperature of 170°C on the copper plate side, a lower plate temperature of 170°C on the silicon plate side, and a set air pressure of 0.11 MPa (converted to a pressure of 40 psi), then subjected to natural cooling, and released. Then, the shim tape was removed, to form an indium layer having an average thickness of 100 µm, to thereby obtain a thermally-conductive sheet of Comparative Example 7.

### (Comparative Example 8)

A commercially available conductive adhesive (thermally-conductive RTV rubber (room temperature curing type) KE3467, obtained from Shin-Etsu Chemical Co., Ltd.) was used instead of the thermally-conductive sheet of Example 1. The conductive adhesive was provided between a nickel-plated copper plate (25 mm × 25 mm, average thickness: 1.00 mm) and a silicon plate (20 mm × 20 mm, average thickness: 0.76 mm), and a shim tape (obtained from MISUMI Group Inc.) having an average thickness of 50 µm was inserted along the periphery of the conductive adhesive. The resulting product was left to stand still at room temperature for one day, and then the shim tape was removed, to form a conductive adhesive layer having an average thickness of 50 µm, to thereby obtain a thermally-conductive sheet of Comparative Example 8.

### <Evaluation>

Next, "thermal conductivity" and "reliability" were evaluated for Examples 1 to 9 and Comparative Examples 1 to 8 as follows. The results are shown in Table 1.

### <Thermal Conductivity>

According to JIS R 1611, the thermal resistance of each thermally-conductive sheet was measured using a NETZSCH laser flash analyzer (LFA467, obtained from NETZSCH-Gerätebau GmbH) at a pulse width of 20 µsec. Next, the thermal resistance of the nickel-plated copper plate (25 mm × 25 mm, average thickness: 1.00 mm) and the silicon plate (20 mm × 20 mm, average thickness: 0.76 mm), which were the base materials used in the measurement, was subtracted from the measured value, to thereby calculate the thermal resistance of the thermally-conductive sheet. Then, the average thickness of the thermally-conductive sheet measured in advance was divided by the thermal resistance, to thereby calculate the thermal conductivity W/(m·K) of the thermally-conductive sheet. The thermal conductivity was evaluated according to the following criteria. The results are shown in Tables 1 to 3.

### [Evaluation Criteria]

⊚: The thermal conductivity was 20 W/m·K or greater.
O: The thermal conductivity was 10 W/m·K or greater and less than 20 W/m·K.
×: The thermal conductivity was less than 10 W/m·K.

### <Reliability>

### <<Production of Laminate after being Pressure-Bonded>>

Each thermally-conductive sheet was sandwiched between a nickel-plated copper plate (25 mm × 25 mm, average thickness: 1.00 mm) and a silicon plate (20 mm × 20 mm, average thickness: 0.76 mm), and hot-pressed by a mini-press for 5 minutes under conditions including an upper plate temperature of 150°C on the copper plate side, a lower plate temperature of 150°C on the silicon plate side, and a set air pressure of 0.11 MPa (converted to a pressure of 40 psi), and then heated in an oven (Perfect Oven PHH-202, obtained from ESPEC CORP.) at 150°C for 1 hour.

### <<Accelerated Life Test and Evaluation of Reliability>>

The laminate after being pressure-bonded was put in a HAST chamber (EHS-212MD, obtained from ESPEC CORP.) at 130°C at a humidity of 85% for 192 hours. Each thermally-conductive sheet after the accelerated life test was observed using a Scanning Acoustic Tomograph (SAT, FS300IIIHR, obtained from Hitachi Power Solutions Co., Ltd.), to inspect adhesiveness with the base materials, and presence or absence of voids. A 7 mm probe for 50 MHz was used for the copper plate side, and a probe for 25 MHz was used for the silicon plate side. The results are shown in Tables 1 to 3.

### [Evaluation Criteria]

⊚: No lifting or delamination of the thermally-conductive sheet from the base materials, and no voids were observed.
O: Lifting or delamination of the thermally-conductive sheet from the base materials, or voids were observed from less than 0.1% the observation field, and the thermally-conductive sheet was within the range suitable for practical use.
×: Lifting or delamination of the thermally-conductive sheet from the base materials, or voids were observed from equal to or greater than 0.1% the observation field, and the thermally-conductive sheet was outside the range suitable for practical use.

**[Table 1]**

| | | Example | | | | | |
|---|---|---|---|---|---|---|---|
| | | 1 | 2 | 3 | 4 | 5 | 6 |
| Pattern | Name | 45° zigzags | 45° zigzags | 45° zigzags | 45° zigzags | 45° zigzags | 45° zigzags |
| | FIG. | FIG. 3A | FIG. 3B | FIG. 3C | FIG. 3A | FIG. 3B | FIG. 3C |
| Diameter of metal projection or length of one side (µm) | | 100 | 100 | 100 | 500 | 500 | 500 |
| Area ratio of metal projection (%) | | 80 | 50 | 20 | 80 | 50 | 20 |
| Average thickness T_{M} (µm) of metal laver | | 18 | 18 | 18 | 18 | 18 | 18 |
| Average thickness Tₘ (µm) of metal projection | | 9 | 9 | 9 | 9 | 9 | 9 |
| Thickness ratio (Tₘ/T_{M}) | | 1 | 1 | 1 | 1 | 1 | 1 |
| Metal part | | Copper | | | | | |
| Non-metal part | | Epoxy resin | | | | | |
| Evaluation | Thermal conductivity | ⊚ | ⊚ | O | ⊚ | ⊚ | O |
| | Reliability | O | ⊚ | ⊚ | O | ⊚ | ⊚ |

**[Table 2]**

| | | Example | | | | | |
|---|---|---|---|---|---|---|---|
| | | 7 | 8 | 9 | 10 | 11 | 12 |
| Pattern | Name | 60° zigzags | Aligned squares | 60° zigzag-arranged regular hexagons | 45° zigzags | 45° zigzags | 45° zigzags |
| | FIG. | FIG. 4A | FIG. 4B | FIG. 4C | FIG. 3B | FIG. 3A | FIG. 3A |
| Diameter of metal projection or length of one side (µm) | | 100 | 100 | 100 | 1,000 | 100 | 100 |
| Area ratio of metal projection (%) | | 80 | 80 | 80 | 50 | 50 | 50 |
| Average thickness T_{M} (µm) of metal layer | | 18 | 18 | 18 | 18 | 36 | 6 |
| Average thickness Tₘ (µm) of metal projection | | 9 | 9 | 9 | 9 | 4.5 | 48 |
| Thickness ratio (Tₘ/T_{M}) | | 1 | 1 | 1 | 1 | 1/8 | 8 |
| Metal part | | Copper | | | | | |
| Non-metal part | | Epoxy resin | | | | | |
| Evaluation | Thermal conductivity | ⊚ | ⊚ | ⊚ | O | ⊚ | O |
| | Reliability | O | O | O | ⊚ | O | ⊚ |

**[Table 3]**

| | | Comparative Example | | | | | | | |
|---|---|---|---|---|---|---|---|---|---|
| | | 1 | 2 | 3 | 4 | 5 | 6 | 7 | 8 |
| Pattern | Name | 45° zigzags | 45° zigzags | 45° zigzags | 45° zigzags | 45° zigzags | 45° zigzags | - | - |
| | FIG. | FIG. 3D | FIG. 3E | FIG. 3D | FIG. 3E | FIG. 3A | FIG. 3A | - | - |
| Diameter of metal projection or length of one side (µm) | | 100 | 100 | 500 | 500 | 100 | 100 | - | - |
| Area ratio of metal projection (%) | | 90 | 10 | 90 | 10 | 80 | 80 | - | - |
| Average thickness T_{M} (µm) of metal layer | | 18 | 18 | 18 | 18 | 36 | 6 | - | - |
| Average thickness Tₘ (µm) of metal projection | | 9 | 9 | 9 | 9 | 4 | 54 | - | - |
| Thickness ratio (Tₘ/T_{M}) | | 1 | 1 | 1 | 1 | 1/9 | 9 | - | - |
| Metal part | | Copper | | | | | | In | Thermally-conductive adhesive |
| Non-metal part | | Epoxy resin | | | | | | - | |
| Evaluation | Thermal conductivity | ⊚ | × | ⊚ | × | ⊚ | × | ⊚ | × |
| | Reliability | × | ⊚ | × | ⊚ | × | ⊚ | × | ⊚ |

The present international application claims priority to Japanese Patent Application No. 2023-205183, filed on December 5, 2023, and the entire contents of Japanese Patent Application No. 2023-205183 are incorporated herein by reference.

### REFERENCE SIGNS LIST

1 thermally-conductive sheet
2 heat spreader
2a main surface
3 heating element (electronic component)
3a upper surface
5 heat sink
6 wiring board
7 thermally-conductive sheet
10 thermally-conductive sheet
11 metal part
11a metal layer
11' metal plate before being etched
11b metal projection
12 adhesive part
13 protective part

## Claims

1. A thermally-conductive sheet, comprising:
a metal part including a metal layer and a metal projection on at least a first surface of the metal layer; and
an adhesive part on the first surface,
wherein an area ratio of the metal projection exposed on the first surface of the thermally-conductive sheet to the first surface is 20% or greater and 80% or less, and
a ratio (Tₘ/T_{M}) of an average thickness (Tₘ) of the metal projection to an average thickness (T_{M}) of the metal layer is 0.125 or greater and 8 or less.

2. The thermally-conductive sheet according to claim 1, further comprising:
a metal projection and an adhesive part on a second surface of the metal layer opposite to the first surface,
wherein an area ratio of the metal projection exposed on the second surface of the thermally-conductive sheet to the second surface is 20% or greater and 80% or less.

3. The thermally-conductive sheet according to claim 1 or 2,
wherein an area ratio of the metal projection exposed on the first surface of the thermally-conductive sheet to the first surface is 30% or greater and 70% or less.

4. The thermally-conductive sheet according to any one of claims 1 to 3,
wherein the ratio (Tₘ/T_{M}) of the average thickness (Tₘ) of the metal projection to the average thickness (T_{M}) of the metal layer is 0.2 or greater and 4 or less.

5. The thermally-conductive sheet according to any one of claims 1 to 4,
wherein a thermal conductivity of the metal layer is 50 W/(m·K) or greater.

6. The thermally-conductive sheet according to any one of claims 1 to 5,
wherein the metal layer contains at least one of gold, silver, copper, aluminum, or nickel.

7. The thermally-conductive sheet according to any one of claims 1 to 6,
wherein the metal projection is a metal formed by electrolytic plating.

8. The thermally-conductive sheet according to any one of claims 1 to 7,
wherein the adhesive part contains at least one of a modified acrylate compound, an epoxy resin, an unsaturated polyester resin, a polyurethane resin, a bismaleimide resin, an alkyd resin, a phenolic resin, or a melamine resin.

9. A thermally-conductive sheet production method, comprising:
applying a protective part to at least a first surface of a metal layer; and
forming a metal projection on an exposed surface of the metal layer to which the protective part is not applied.

10. The thermally-conductive sheet production method according to claim 9, further comprising:
removing the protective part; and
filling an adhesive part on an exposed surface of the metal layer from which the protective part is removed.

11. The thermally-conductive sheet production method according to claim 9 or 10,
wherein the applying of the protective part includes applying the protective part to the first surface of the metal layer and to a second surface of the metal layer opposite to the first surface.
